# EUROPÄISCHE PATENTSCHRIFT

(11) **EP 2 180 535 B1**
(45) Veröffentlichungstag und Bekanntmachung des Hinweises auf die Patenterteilung: **10.11.2010**
(21) Anmeldenummer: 08018624.0
(22) Anmeldetag: 24.10.2008
(51) Int. Cl.: H01L 41/08

(54) **Einstellvorrichtung**
Setting device
Dispositif de réglage

(43) Veröffentlichungstag der Anmeldung: 28.04.2010
(73) Patentinhaber: Physik Instrumente (PI) GmbH & Co. KG, 76228 Karlsruhe (DE)
(72) Erfinder: Müller, Klaus-Dieter, 76337 Waldbronn (DE)

(56) Entgegenhaltungen:
- EP-A- 1 870 614
- HOLTERMAN J ET AL: "Active damping within an advanced microlithography system using piezoelectric Smart Discs" MECHATRONICS, PERGAMON PRESS, OXFORD, GB, Bd. 14, Nr. 1, 1. Februar 2004 (2004-02-01), Seiten 15-34, XP004458870 ISSN: 0957-4158

## Beschreibung

Die Erfindung betrifft eine Vorrichtung zur Einstellung des Übersprechens zwischen einem Aktorabschnitt und einem Sensorabschnitt eines Piezoelements, wobei das Piezoelement kraftbeaufschlagt ist, so dass eine von außen wirkende, mittels des Sensorabschnitts zu messende Kraft auf das Piezoelement einwirkt, und wobei am Aktorabschnitt eine elektrische Spannung anliegt.

Es sind Piezoelemente bekannt, die einen elektrisch angesteuerten, aktiven Abschnitt (Aktorabschnitt) mit piezoelektrischem Material und einen elektrisch nicht angesteuerten passiven Abschnitt (Sensorabschnitt) mit piezoelektrischem Material aufweisen. Die beschriebene Kombination aus Aktorabschnitt und Sensorabschnitt wird auch als Aktor-Sensor-Stapel bezeichnet. Durch Spannungsbeaufschlagung des Aktorabschnitts kommt es - bedingt durch den inversen piezoelektrischen Effekt - zu einer Ausdehnung beispielswiese in Längserstreckungsrichtung des Piezoelements, wodurch ein an dem Piezoelement anliegendes Element bewegt bzw. verschoben werden kann. Der Sensorabschnitt detektiert eine Kraft, zum Beispiel eine Gegenkraft, welche durch die von dem Piezoelement auf das zu bewegende bzw. zu verschiebende Element ausgeübte Kraft hervorgerufen wird. Der Sensorabschnitt kann aber auch andere externe und auf das Piezoelement einwirkende Kräfte, z.B. Beschleunigungskräfte, auf die bewegte Masse detektieren. Bei besagtem Sensorabschnitt wird dabei der piezoelektrische Effekt ausgenutzt, d.h. durch die auf den Sensorabschnitt ausgeübte Kraft wird dieser deformiert und es werden innerhalb des piezoelektrischen Materials Ladungen generiert, die ihrerseits eine elektrische Spannung erzeugen, die an dem Sensorabschnitt abgreifbar ist. Diese so generierte elektrische Spannung ist proportional der auf den Sensorabschnitt einwirkenden Kraft, so dass eine Kraftmessung bzw. Kraftsensierung möglich ist.

Durch die elektrische Ansteuerung des Aktorabschnitts kommt es jedoch zu einer Beeinflussung der Ladungsentstehung in dem Sensorabschnitt. Beispielsweise kommt es bei einer Ausdehnung des Aktorabschnitts in Längserstreckungsrichtung des Piezoelements auch zu einer Kontraktion des Aktorabschnitts in den zur Längserstreckungsrichtung senkrechten Richtungen, wobei sich diese Kontraktion auf den Sensorabschnitt zumindest teilweise überträgt, wodurch seinerseits ebenfalls Ladungen in dem Sensorabschnitt generiert werden. Es tritt also der Effekt des Übersprechens zwischen dem Aktorabschnitt und dem Sensorabschnitt auf, so dass das eigentliche Messsignal - hervorgerufen durch die von außen auf das Piezoelement einwirkende Kraft - eine Überlagerung erfährt und der entsprechende zu detektierende Wert verfälscht wird.

Eine Möglichkeit, besagtes Übersprechen bei einem Aktor-Sensor-Stapel zu reduzieren, besteht darin, einen speziellen Aufbau für das Piezoelement zu wählen. Hierzu wird beispielsweise zwischen den Bereich des Aktorabschnitts und den Bereich des Sensorabschnitts ein Abschnitt eines mechanisch anisotropen Materials angeordnet. Jedoch ergibt sich hierdurch eine signifikante geometrische Änderung des Stapeldesigns, was u.a. zu einer Reduzierung der Stapelsteifigkeit bei gegebener Grundfläche und zu einem komplexeren Aufbau führen kann. Besagte Reduzierung der Stapelsteifigkeit ist jedoch insbesondere im Hinblick auf Anwendungen betreffend aktive Schwingungsdämpfung nachteilig.

Eine Möglichkeit zur kompletten Vermeidung des Übersprechens ist die räumliche Trennung von Aktorabschnitt und Sensorabschnitt. Hierdurch ergibt sich jedoch in nachteiliger Weise ein komplexerer Aufbau mit erhöhtem Platzbedarf.

Das Übersprechverhalten kann ebenfalls elektronisch beeinflusst werden, indem aufwendige Algorithmen in die elektrischen bzw. elektronischen Ansteuerungsvorrichtungen implementiert werden, welche aber die maximal mögliche Regelbandbreite des Gesamtsystems limitieren. Eine derartige Vorrichtung ist aus dem Artikel von J. Holterman et al. in Mechatronics, Bd. 14 (2004), S. 15-34 bekannt.

Die Aufgabe der Erfindung besteht deshalb darin, die oben genannten Nachteile des Stands der Technik zu überwinden, und insbesondere eine Vorrichtung bereitzustellen, die eine gezielte Einstellung des Übersprechens zwischen dem aktiven und dem passiven Abschnitt eines Piezoelements erlaubt.

Diese Aufgabe wird erfindungsgemäß gelöst durch eine Vorrichtung der eingangs genannten Art, die ein kraftfreies Kompensationspiezoelement umfasst, das einen Aktorbereich und einen Sensorbereich aufweist, wobei am Aktorbereich ebenfalls eine elektrische Spannung anliegt, und der Sensorabschnitt des Piezoelements und der Sensorbereich des Kompensationspiezoelements elektrisch miteinander verbunden sind.

Hierbei kann es von Vorteil sein, dass an dem Aktorbereich des Kompensationspiezoelements eine elektrische Spannung angelegt ist, die invers zu der am Aktorabschnitt des Piezoelements angelegten Spannung ist. Invers bedeutet in diesem Zusammenhang, dass die beiden elektrischen Spannungen gegensätzliche Polarität aufweisen. Durch besagte inverse Spannungsbeaufschlagung des Aktorabschnitts des Piezoelements und des Aktorbereichs des Kompensationspiezoelements kommt es zu gegensätzlichen Ausdehnungen bzw. Deformationen. Während sich der Aktorabschnitt des Piezoelements beispielsweise in Längserstreckungsrichtung des Piezoelements ausdehnt, kommt es zu einer Kontraktion in Längserstreckungsrichtung des Aktorbereichs des Kompensationspiezoelements. Dadurch kommt es auch zu gegensätzlichen Deformationen in dem Sensorabschnitt des Piezoelements und in dem Sensorbereich des Kompensationspiezoelements, weshalb sich elektrische Spannungen gegensätzlicher Polarität an dem Sensorabschnitt des Piezoelements und an dem Sensorbereich des Kompensationspiezostapels ergeben. Werden nun der Sensorabschnitt des Piezoelements und der Sensorbereich des Kompensationspiezoelements entsprechend elektrisch miteinander verschaltet, so dass es zu einer Addition der inversen Spannungen kommt, ergibt sich effektiv eine Subtraktion besagter elektrischer Spannungen. Da das Piezoelement mit einer äußeren Kraft beaufschlagt ist, die eine zusätzliche Deformation im Sensorabschnitt des Piezoelements erzeugt, liefert die Addition der elektrischen Spannungen gegensätzlicher Polarität das eigentliche, durch den Sensorabschnitt des Piezoelements zu detektierende Signal.

Ebenso kann es von Vorteil sein, dass am Aktorbereich des Kompensationspiezoelements die gleiche elektrische Spannung anliegt wie am Aktorabschnitt des Piezoelements, und dass der Sensorabschnitt des Piezoelements elektrisch invers mit dem Sensorbereich des Kompensationspiezoelements verbunden ist. Daneben kann es vorteilhaft sein, dass bei gleicher elektrischer Spannung am Aktorbereich des Kompensationspiezoelements und am Aktorabschnitt des Piezoelements der Sensorabschnitt des Piezoelements eine zu dem Sensorbereich des Kompensationspiezoelements inverse Polarität aufweist. Beide zuvor genannten vorteilhaften Ausführungsformen erweitern die konstruktiven Möglichkeiten zur Realisierung der erfindungsgemäßen Vorrichtung.

Es kann weiterhin von Vorteil sein, dass das Piezoelement und/oder das Kompensationspiezoelement zumindest abschnittsweise einen Multilayeraufbau aufweisen/aufweist. Durch einen Multilayeraufbau, bei welchem der Aktorabschnitt und/oder der Sensorabschnitt des Piezoelements und/oder der Aktorbereich und/oder der Sensorbereich des Kompensationspiezoelements zumindest abschnittsweise Schichten piezokeramischen Materials aufweisen/aufweist mit zwischen den piezokeramischen Schichten angeordneten Elektroden, können im Falle des inversen piezoelektrischen Effekts bei gleichen an das Piezoelement angelegten elektrischen Spannungen größere Ausdehnungen erzielt werden als bei Verwendung eines kompakten und nicht in Schichten aufgebauten Piezoelements. Ebenso können im Falle des piezoelektrischen Effekts bei gleichen an das Piezoelement angelegten äußeren Kräften größere Ladungsmengen erzielt werden als bei Verwendung eines kompakten und nicht in Schichten aufgebauten Piezoelements. Hierbei ist eine diskrete Einstellung des Übersprechens möglich, indem am aus mehreren Piezoschichten bzw. -scheiben bestehende Sensorbereich des Kompensationspiezostapels nicht alle Schichten bzw. Scheiben elektrisch kontaktiert werden. Somit kann die erzeugte Ladungsmenge gezielt eingestellt werden.

Zudem kann es von Vorteil sein, dass sich der Aufbau des Piezoelements vom Aufbau des Kompensationspiezoelement zumindest abschnittsweise unterscheidet, bzw. dass das Piezoelement wenigsten abschnittsweise eine andere piezoelektrische Keramik aufweist als das Kompensationspiezoelement, bzw. dass das Piezoelement zumindest abschnittsweise eine andere Geometrie als das Kompensationspiezoelement aufweist. Hierdurch ist es möglich, eine gezielte Einstellung des Übersprechverhaltens zu erreichen, da die erzeugte elektrische Ladungsmenge eines Piezoelements von dessen lateraler Ausdehnung, dessen Dicke und von der Materialart beeinflusst wird.

Alle Piezomaterialien können für den Aktorabschnitt bzw. -bereich und den Sensorabschnitt bzw. -bereich Verwendung finden. Speziell für den Aktorabschnitt und/oder den Aktorbereich würden sich auch je nach Anwendung elektrostriktive Materialien eignen. Die Eigenschaften dieser Materialien besitzen zwar gegenüber den meisten piezoektrischen Materialien eine höher Temperaturempfindlichkeit, zeigen dafür aber ein lineareres Verhalten zwischen dem elektrischen Ansteuersignal und der mechanischen Auslenkung.

Eine Möglichkeit zur stufenlosen Einstellung des elektrischen Übersprechens ist das Vorsehen eines elektrischen Widerstands, der zum Sensorabschnitt des Piezoelements oder zum Sensorbereich des Kompensationspiezoelements in Serie geschaltet ist. Hierfür ist u.U. eine elektrisch separate Ansteuerung der Aktoren notwendig.

Eine weitere Möglichkeit zur stufenlosen Einstellung des Übersprechens besteht in der gezielt unterschiedlichen elektrischen Ansteuerung der Aktoren. Allerdings wären hierfür zwei unterschiedliche elektrische Spannungsversorgungseinrichtungen notwendig.

Die Erfindung betrifft zudem ein Bauteil mit einer Vorrichtung gemäß zumindest einer der zuvor beschriebenen vorteilhaften Ausführungsformen.

Hierbei kann es von Vorteil sein, dass das Piezoelement mechanisch in das Bauteil integriert ist. Beispielsweise ist das Piezoelement in dem Bauteil eingespannt und befindet sich dabei mit seinem aktiven Aktorabschnitt in Anlage mit einem festen und unverrückbaren bzw. unverschiebbaren Bauteilabschnitt, während sich der passive Sensorabschnitt in Anlage mit einem zumindest bereichsweise verschiebbaren Bauteilabschnitt, z.B. dem Schenkel eines Festkörpergelenks, befindet. Durch die Integration des Piezoelements in das Bauteil bzw. dessen Mechanik resultiert eine sehr kompakte Bauweise des Bauteils.

Die Erfindung betrifft zudem ein Verfahren zur Einstellung des Übersprechens zwischen einem elektrisch angesteuerten, aktiven Abschnitt und einem elektrisch nicht angesteuerten, passiven Abschnitt piezoelektrischen Materials eines Piezoelements, wobei das erfindungsgemäße Verfahren folgende Schritte umfasst: Anlegen einer elektrischen Spannung an den Aktorabschnitt des Piezoelements, wodurch es zu einer Deformation des Piezoelements kommt; Aufbringen einer von außen auf das Piezoelement einwirkenden Kraft; Vorsehen eines kraftfreien Kompensationspiezoelements, welches einen Aktorbereich und einen Sensorbereich aufweist; Anlegen einer elektrischen Spannung an den Aktorbereich des Kompensationspiezoelements und Vorsehen einer elektrischen Verbindung zwischen dem Sensorbereich des Kompensationspiezoelements und dem Sensorabschnitt des Piezoelements.

Bei dem erfindungsgemäßen Verfahren kann vorteilhaft sein, dass an den Aktorbereich des Kompensationspiezoelements eine elektrische Spannung angelegt wird, die gleich groß, jedoch invers zu der an den Aktorabschnitt des Piezoelements angelegten elektrischen Spannung ist. Zudem kann es bei Beaufschlagung des Aktorabschnitts des Piezoelements und des Aktorbreichs des Kompensationspiezoelements mit einer gleichen Spannung vorteilhaft sein, dass der Sensorabschnitt des Piezoelements elektrisch invers mit dem Sensorbereich des Kompensationspiezoelements verbunden wird. Die beiden zuvor genannten vorteilhaften Ausführungsformen erweitern die Möglichkeiten zur Ausgestaltung des erfindungsgemäßen Verfahrens.

Die Erfindung wird nachfolgend anhand von Ausführungsbeispielen unter Zuhilfenahme von Figuren näher erläutert.

Es zeigen:
- Fig. 1: Schematische Darstellung zur Erläuterung des Einflusses des Aktorab- schnitts eines Aktor-Sensor-Stapels auf dessen Sensorabschnitt
- Fig. 2: Schematische Darstellung der erfindungsgemäßen Vorrichtung
- Fig. 3: Schematische Darstellung zur Verdeutlichung einer möglichen Anord- nungssituation der erfindungsgemäßen Vorrichtung in einem Bauteil
- Fig.4: Flussdiagramm zur Darstellung des erfindungsgemäßen Verfahrens

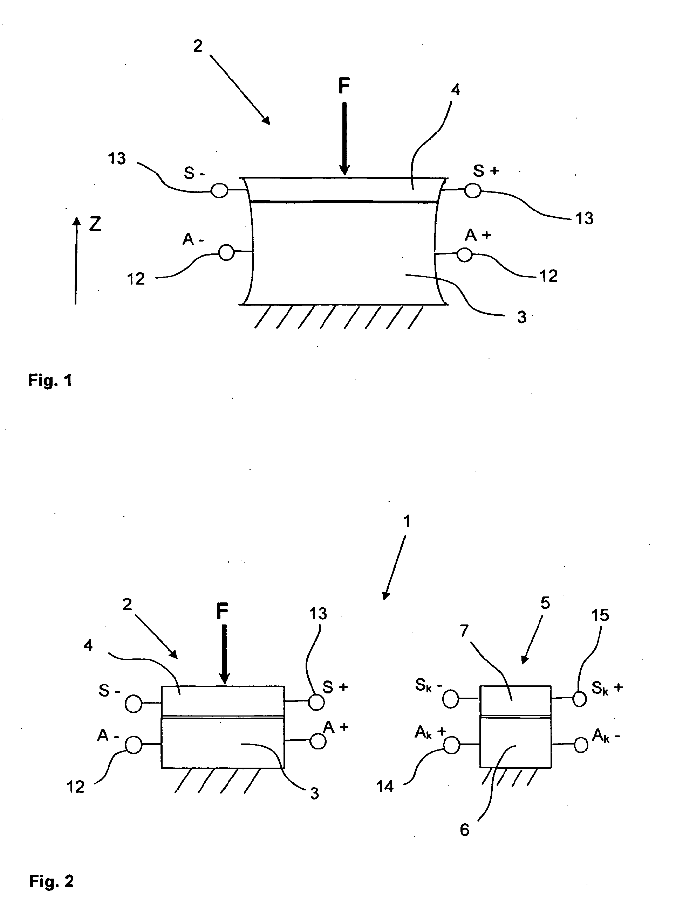

Fig. 1 zeigt eine schematische Darstellung zur Erläuterung der Einwirkung des elektrisch angesteuerten, aktiven Aktorabschnitts 3 des Piezoelements 2 auf dessen elektrisch nicht angesteuerten, passiven Sensorabschnitt 4. Durch Anlegen einer Spannung an den Aktorabschnitt 3 bzw. an dessen Kontaktierungseinrichtungen 12 kommt es hier beispielhaft zu einem Ausdehnen des Piezoelements in dessen Längserstreckungsrichtung (in positiver Z-Richtung, d.h. in Fig. 1 nach oben). Die Polarität der jeweiligen Kontaktierungseinrichtung 12 ist in Fig. 1 gekennzeichnet durch die Beschriftungen A - und A +, wobei der Buchstabe ,A' für Aktor steht.

Durch oben beschriebenes Ausdehnen ist beabsichtigt, ein an dem Sensorabschnitt 4 anliegendes, in der Zeichnung nicht dargestelltes Element, beispielswiese den Schenkel eines Festkörpergelenks in einem Bauteil, zu verschieben. Diese Verschiebung bewirkt eine Gegenkraft F, die von dem nun verschobenen Element auf den Sensorabschnitt 4 wirkt. Gleichzeitig kommt es durch besagtes Ausdehnen zu einer Kontraktion des Aktorabschnitts 3 quer zur Z-Richtung, d.h. es kommt zu einer Querkontraktion des Aktorabschnitts 3. Der mit dem Aktorabschnitt 3 verbundene Sensorabschnitt 4 ist gezwungen, wenigstens bereichsweise ebenfalls eine Querkontraktion zu vollführen. Die entsprechende mechanische Deformation generiert in dem Sensorabschnitt 4 elektrische Ladungen, die sich makroskopisch - vorausgesetzt, es existiert ein hoher elektrischer Abschlusswiderstand - als elektrische Spannung, die an dem Sensorabschnitt 4 bzw. dessen Kontaktierungseinrichtungen 13 abgreifbar ist, bemerkbar macht. Hierbei sind die Polaritäten der jeweiligen Kontaktierungseinrichtung durch die Beschriftungen S - und S + gekennzeichnet, wobei der Buchstabe ,S' für Sensor steht.

Sowohl der Aktorabschnitt 3, als auch der Sensorabschnitt 4 des Piezoelements 2 von Fig. 1 besteht aus einer kompakten bzw. einlagigen oder einschichtigen Piezokeramik. Jedoch ist es ebenso möglich, den Aktorabschnitt 3 und/oder den Sensorabschnitt 4 als mehrlagige Piezokeramik auszuführen (Multilayeraufbau). Es ist weiterhin möglich, anstatt einer Piezokeramik andere Piezomaterialien einzusetzen. Hierfür eignet sich beispielsweise ein elektrostriktives Material, dass insbesondere für den Aktorabschnitt 3 verwendet werden kann.

Fig. 2 zeigt eine schematische Darstellung der erfindungsgemäßen Vorrichtung. Einerseits umfasst die erfindungsgemäße Vorrichtung 1 das Piezoelement 2 gemäß Fig. 1, welches mit einer äußeren Kraft F beaufschlagt ist. Daneben umfasst die erfindungsgemäße Vorrichtung das Kompensationspiezoelement 5, das einen elektrisch angesteuerten, aktiven Aktorbereich 6 und einen elektrisch nicht angesteuerten, passiven Sensorbereich 7 aufweist. Das Kompensationspiezoelement 5 ist im Gegensatz zum Piezoelement 2 nicht mit einer äußeren Kraft beaufschlagt, es ist somit kraftfrei.

An dem Aktorabschnitt 3 des Piezoelements 2 bzw. an dessen Kontaktierungsvorrichtungen 12 ist eine elektrische Spannung angelegt. Wiederum sind die Polaritäten an den Kontaktierungseinrichtungen 12 durch die Beschriftungen A - und A + gekennzeichnet. Eine vom Betrag genauso hohe, jedoch inverse Spannung ist an dem Aktorbereich 6 des Kompensationspiezoelements 5 angelegt. Dies wird in Fig. 2 dadurch verdeutlicht, dass die Polaritäten der Kontaktierungseinrichtungen 14 (Beschriftungen Aₖ - und Aₖ +) genau entgegengesetzt sind zu den Polaritäten der Kontaktierungseinrichtungen 12 des Piezoelements 2. Der Sensorabschnitt 4 des Piezoelements 2 ist elektrisch mit dem Sensorbereich 7 des Kompensationspiezoelements 5 verbunden (aus Übersichtlichkeitsgründen nicht in Fig. 2 dargestellt). Die Polaritäten am Sensorbereich 7 des Kompensationspiezoelements (Sₖ - und Sₖ +) sind identisch zu den Polaritäten am Sensorabschnitt 4 des Piezoelements 2.

Sowohl der Aktorbereich 6, als auch der Sensorbereich 7 des Kompensationspiezoelements 2 gemäß Fig. 2 besteht aus einer kompakten bzw. einlagigen oder einschichtigen Piezokeramik. Jedoch ist es ebenso möglich, den Aktorbereich 6 und/oder den Sensorbereich 7 als mehrlagige Piezokeramik auszuführen (Multilayeraufbau). Es ist weiterhin möglich, anstatt einer Piezokeramik andere Piezomaterialien einzusetzen. Hierfür eignet sich beispielsweise ein elektrostriktives Material, dass insbesondere für den Aktorbereich 6 verwendet werden kann.

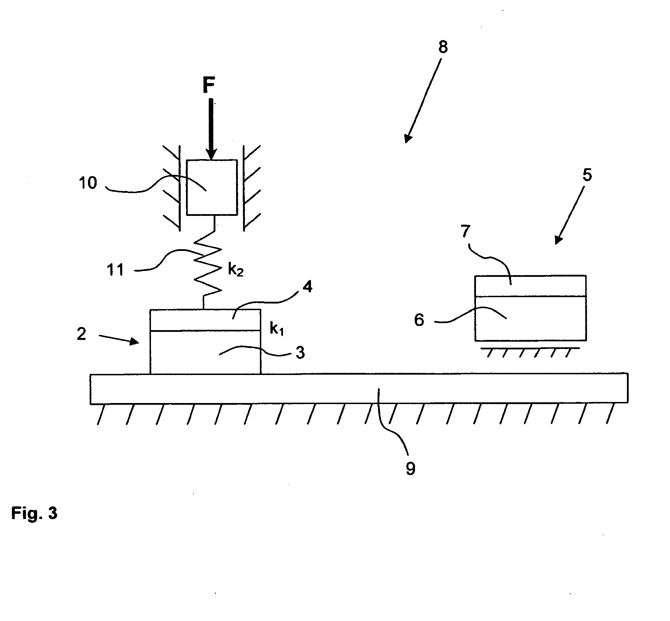

Fig. 3 zeigt eine schematische Darstellung zur Verdeutlichung einer möglichen Anordnungssituation der erfindungsgemäßen Vorrichtung. Das in eine Mechanik 8 eines in Fig. 3 nicht dargestellten Bauteils integrierte Piezoelement 2 ist direkt an eine Basis 9 der Mechanik angekoppelt. Mit einer zu bewegenden Masse 10 ist das Piezoelement 2 über eine Struktur 11 verbunden, die sich durch eine hohe Steifigkeit k₂ in vertikaler, d.h. in Piezostellrichtung, auszeichnet und in zur Piezostellrichtung orthogonaler Richtung nachgiebiger ausgelegt ist. Weiterhin ist die zu bewegende Masse 10 mechanisch geführt. Diese zwei Maßnahmen schützen die auf Zugkräfte empfindliche Piezokeramik des Piezoelements 2 vor Überlast und somit einer Zerstörung. Für eine ausreichende Funktionalität der Piezoauslenkungs- und Kraftübertragung und deren Detektion durch den Sensorabschnitt 4 muss die Steifigkeit k₁ des Piezoelements 2 in Kraft- und Auslenkungsrichtung der Steifigkeit k₂ der mechanischen Ankopplung durch die Struktur 11 angepasst werden.

Das Kompensationspiezoelement 5 kann in das Bauteil bzw. in dessen Mechanik integriert sein, in dem es von der Basis 9 beabstandet und losgelöst ist, oder aber mechanisch mit der Basis 9 verbunden ist.

Eine weitere Möglichkeit der Integration der erfindungsgemäßen Vorrichtung in die Mechanik eines Bauteils ist die Implementierung in eine Mechanikstruktur ohne das Vorsehen von Ankopplungselementen, wobei es hierbei notwendig ist, das Piezoelement und die auf das Piezoelement von außen einwirkenden Kräfte so zu bemessen, dass es zu keiner Schädigung der Keramik kommen kann.

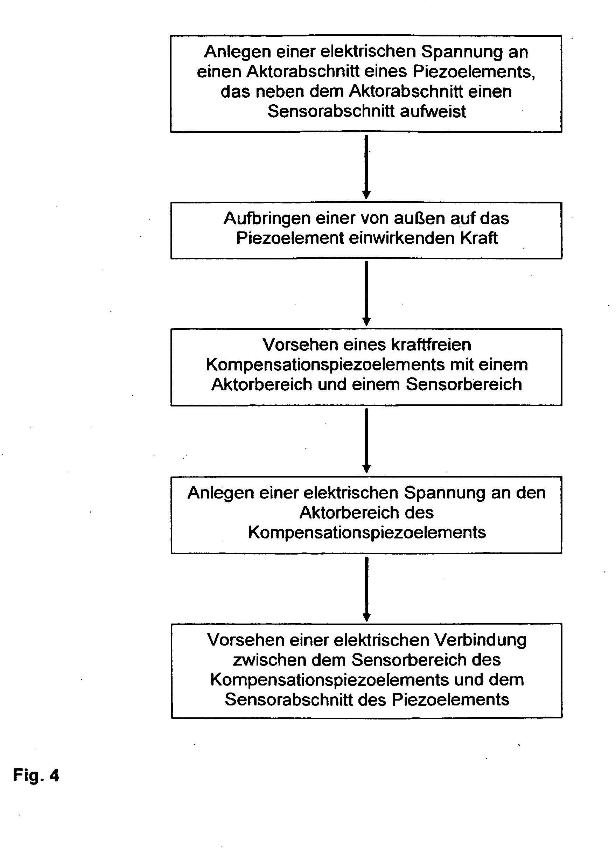

Fig.4 zeigt ein Flussdiagramm, welches das erfindungsgemäße Verfahren zur Einstellung des Übersprechens zwischen einem Aktorabschnitt und einem Sensorabschnitt eines Piezoelements verdeutlicht. Als erster Schritt des Verfahrens erfolgt das Anlegen einer elektrischen Spannung an den Aktorabschnitt des Piezoelements, wodurch es zu einer Deformation des Piezoelements kommt. Diese Deformation gliedert sich auf in eine beabsichtigte Haupt-Deformation, beispielsweise in Längserstreckungsrichtung des Piezoelements, und in unbeabsichtigte, aber zwangsläufig vorhandene Neben-Deformationen, beispielsweise in zur Längserstreckungsrichtung des Piezoelements im Wesentlichen senkrechten Richtungen. Als nächster Schritt folgt das Aufbringen einer von außen auf das Piezoelement einwirkenden Kraft, die beispielsweise in einer zur Haupt-Deformation des Piezoelements im Wesentlichen entgegengesetzten Richtung wirkt. Diese äußere Kraft kann zum Beispiel eine Gegenkraft sein, die aufgrund der Deformation des Piezoelements in Hauptrichtung hervorgerufen wird. Danach erfolgt das Vorsehen eines kraftfreien Kompensationspiezoelements, welches einen elektrisch angesteuerten, aktiven Aktorbereich und einen elektrisch nicht angesteuerten, passiven Sensorbereich aufweist. In einem weiteren Schritt wird eine elektrische Spannung an den Aktorbereich des Kompensationspiezoelements angelegt. Diese Spannung kann betragsmäßig gleich, größer oder kleiner als die am Aktorabschnitt anliegende Spannung sein. Sie kann hierbei auch invers zur am Aktorabschnitt anliegenden Spannung sein, d.h eine entgegengesetzte Polarität zur am Aktorabschnitt anliegenden Spannung aufweisen. Als letzter Schritt des erfindungsgemäßen Verfahrens erfolgt das Vorsehen einer elektrischen Verbindung zwischen dem Sensorbereich des Kompensationspiezoelements und dem Sensorabschnitt des Piezoelements.

Nachfolgend wird die Funktionsweise der erfindungsgemäßen Vorrichtung näher erläutert.

Die erfindungsgemäße Vorrichtung erlaubt das gezielte Einstellen bzw. die gezielte Reduzierung oder sogar die Vermeidung des Effekts des Übersprechens bei einem Piezoelement, welches einen elektrisch angesteuerten, aktiven Aktorabschnitt zur aktorischen Bewegung und einen elektrisch nicht angesteuerten, passiven Sensorabschnitt zur Sensierung bzw. Detektierung einer äußeren Kraft auf das Piezoelement aufweist (Aktor-Sensor-Stapel). Bei solch einem Aktor-Sensor-Stapel tritt generell das Problem des mechanischen bzw. elektrischen Übersprechens auf. Durch die elektrische Ansteuerung des Aktorabschnitts - d.h. der Aktorabschnitt wird mit einer elektrischen Spannung beaufschlagt - kommt es zu einer mechanischen Deformation des Aktorabschnitts, die gewollt und beabsichtigt ist, um hierdurch eine Bewegung oder Verschiebung eines mit dem Piezoelement in Kontakt stehenden Elements zu bewirken. Gleichzeitig erzeugt die beabsichtigte Deformation des Aktorabschnitts eine unbeabsichtigte Deformation des mit dem Aktorabschnitt verbundenen Sensorabschnitts. Diese unbeabsichtigte Deformation innerhalb des Sensorabschnitts führt dazu, dass eine am Sensorabschnitt abgreifbare elektrische Spannung generiert wird. Durch eine von außen auf das Piezoelement einwirkende Kraft, beispielsweise hervorgerufen durch eine Gegenkraft des durch das Piezoelement bewegten bzw. verschobenen Elements, werden zusätzliche Ladungen in dem Sensorabschnitt des Piezoelements generiert, und die entsprechende elektrische Spannung überlagert sich der Spannung, die durch besagte unbeabsichtigte Deformation des Sensorabschnitts hervorgerufen wird. Die gesamte am Sensorabschnitt abgegriffene Spannung stellt somit eine Überlagerung der durch die äußere Kraft hervorgerufene Spannung und der durch die unbeabsichtigte Deformation hervorgerufene Spannung dar. Von Interesse ist jedoch lediglich die durch die äußere Kraft hervorgerufene Spannung, die es zu detektieren gilt. Die durch die unbeabsichtigte Deformation hervorgerufene Spannung bewirkt somit eine Verfälschung des zu messenden Kraftsignals.

Die erfindungsgemäße Vorrichtung erlaubt es nun, besagte Verfälschung drastisch zu minimieren bzw. ganz zu beseitigen, indem die Vorrichtung ein Kompensationspiezoelement aufweist, das einen elektrisch angesteuerten, aktiven piezoelektrischen Aktorbereich und einen elektrisch nicht angesteuerten, passiven piezoelektrischen Sensorbereich umfasst. Das Kompensationspiezoelement der erfindungsgemäßen Vorrichtung ist jedoch im Gegensatz zum Piezoelement kraftfrei, d.h. es wirkt keine äußere Kraft auf das Kompensationspiezoelement ein. Durch Anlegen einer elektrischen Spannung an den Aktorbereich des Kompensationspiezoelements, die der am Aktorabschnitt des Piezoelements angelegten Spannung entspricht, jedoch beispielsweise invers zu dieser ist, kommt es zu einer im Vergleich zum Aktorabschnitt entgegengesetzten Deformation innerhalb des Aktorbereichs. Beispielsweise bewirkt die am Aktorabschnitt des Piezoelements angelegte elektrische Spannung eine Ausdehnung in Längserstreckungsrichtung des Piezoelements, so dass die am Aktorabschnitt des Kompensationspiezoelements anliegende inverse Spannung eine Kontraktion in Längserstreckungsrichtung des Kompensationspiezoelements bewirkt. Demgemäß sind auch die in dem Sensorabschnitt des Piezoelements bzw. in dem Sensorbereich des Kompensationspiezoelements erzeugten Deformationen entgegengesetzt, so dass in entsprechender Weise zwar im Wesentlichen gleich große, aber inverse elektrische Spannungen generiert werden.

Da der Sensorabschnitt des Piezoelements entsprechend elektrisch mit dem Sensorbereich des Kompensationspiezoelements verbunden ist, kommt es zu einem teilweisen Aufheben der elektrischen Spannungen, d.h. die in dem Sensorabschnitt bzw. dem Sensorbereich generierten elektrischen Spannungen resultierend aus den Deformationen des Aktorabschnitts bzw. des Aktorbereichs heben sich auf. Weil das Piezoelement aber zusätzlich mit einer äußeren Kraft beaufschlagt ist, die eine zusätzliche elektrische Spannung in dem Aktorabschnitt generiert, verbleibt am Sensorabschnitt des Piezoelements eine abgreifbare Spannung, welche im Wesentlichen das zu detektierende Kraftsignal in unverfälschter Weise widerspiegelt.

Neben dem Beaufschlagen mit inversen elektrischen Spannungen ist es ebenso möglich, den Aktorabschnitt des Piezoelements und den Aktorbereich des Kompensationspiezoelements mit Spannungen gleicher Polarität zu beaufschlagen, und dafür eine gegenüber der Beaufschlagung mit inversen Spannungen invertierte elektrische Kontaktierung des Sensorabschnitts des Piezoelements und des Sensorbereichs des Kompensationspiezoelements vorzunehmen, oder aber invertierte Polaritäten bezüglich des Sensorabschnitts und des Sensorbereichs vorzusehen. Weiterhin ist es natürlich ebenso möglich, beim Aktorabschnitt des Piezoelements und beim Aktorbereich des Kompensationspiezoelements unterschiedliche Polaritäten vorzusehen.

Mit der erfindungsgemäßen Vorrichtung ist es möglich, ein sehr hohes Verhältnis - bis zu einigen Größenordnungen - zwischen dem Nutzsignal, hervorgerufen durch die Aufbringung einer äußeren Kraft auf das Piezoelement und zu detektieren mit Hilfe des Sensorabschnitts, relativ zum Betrag des Übersprechens, hervorgerufen durch die Deformation des Aktorabschnitts der Piezoelements, zu erreichen.

Die Einstellvorrichtung ermöglicht hierbei nicht nur die Amplitude des Übersprechens einzustellen, sondern ebenfalls die Phasenlage des Sensorabschnittsignals zum Ansteuerungssignal des Aktorabschnitts.

## Patentansprüche

1. Vorrichtung (1) zur Einstellung des Übersprechens zwischen einem Aktorabschnitt (3) und einem Sensorabschnitt (4) eines Piezoelements (2), wobei das Piezoelement (2) kraftbeaufschlagt ist, so dass eine von außen wirkende, mittels des Sensorabschnitts (4) zu messende Kraft auf das Piezoelement (2) einwirkt, und wobei am Aktorabschnitt (3) eine elektrische Spannung anliegt
**dadurch gekennzeichnet, dass**
die Vorrichtung (1) weiterhin ein kraftfreies Kompensationspiezoelement (5) umfasst, das einen Aktorbereich (6) und einen Sensorbereich (7) aufweist, wobei am Aktorbereich (6) ebenfalls eine elektrische Spannung anliegt, und der Sensorabschnitt (4) des Piezoelements (2) und der Sensorbereich (7) des Kompensationspiezoelements (5) elektrisch miteinander verbunden sind.

2. Vorrichtung nach Anspruch 1, **dadurch gekennzeichnet, dass** am Aktorbereich (6) des Kompensationspiezoelements (5) die gleiche, jedoch inverse elektrische Spannung wie am Aktorabschnitt (3) des Piezoelements (2) anliegt.

3. Vorrichtung nach Anspruch 1, **dadurch gekennzeichnet, dass** am Aktorbereich (6) des Kompensationspiezoelements (5) die gleiche elektrische Spannung anliegt wie am Aktorabschnitt (3) des Piezoelements (2), und dass der Sensorabschnitt (4) des Piezoelements (2) elektrisch invers mit dem Sensorbereich (7) des Kompensationspiezoelements (5) verbunden ist.

4. Vorrichtung nach Anspruch 1, **dadurch gekennzeichnet, dass** am Aktorbereich (6) des Kompensationspiezoelements (5) die gleiche elektrische Spannung anliegt wie am Aktorabschnitt (3) des Piezoelements (2), und dass der Sensorabschnitt (4) des Piezoelements (2) eine zu dem Sensorbereich (7) des Kompensationspiezoelements (5) inverse Polarität aufweist.

5. Vorrichtung nach zumindest einem der vorangegangenen Ansprüche, **dadurch gekennzeichnet, dass** das Piezoelement (2) und/oder das Kompensationspiezoelement (5) zumindest abschnittsweise einen Multilayeraufbau aufweisen/aufweist.

6. Vorrichtung nach zumindest einem der vorangegangenen Ansprüche, **dadurch gekennzeichnet, dass** sich der Aufbau des Piezoelements (2) zumindest abschnittsweise vom Aufbau des Kompensationspiezoelement (5) unterscheidet.

7. Vorrichtung nach zumindest einem der vorangegangenen Ansprüche, **dadurch gekennzeichnet, dass** das Piezoelement (2) wenigstens abschnittsweise eine andere piezoelektrische Keramik aufweist als das Kompensationspiezoelement (5).

8. Vorrichtung nach zumindest einem der vorangegangenen Ansprüche, **dadurch gekennzeichnet, dass** das Piezoelement (2) zumindest abschnittsweise eine andere Geometrie aufweist als das Kompensationspiezoelement (5).

9. Bauteil mit einer Vorrichtung gemäß zumindest einem der vorangegangenen Ansprüche.

10. Bauteil nach Anspruch 9, **dadurch gekennzeichnet, dass** das Piezoelement (2) mechanisch in das Bauteil integriert ist.

11. Verfahren zur Einstellung des Übersprechens zwischen einem Aktorabschnitt (3) und einem Sensorabschnitt (4) eines Piezoelements (2), umfassend folgende Schritte:
- Anlegen einer elektrischen Spannung an den Aktorabschnitt (3) des Piezoelements (2), wodurch es zu einer Deformation des Piezoelements (2) kommt;
- Aufbringen einer von außen auf das Piezoelement (2) einwirkenden Kraft;
- Vorsehen eines kraftfreien Kompensationspiezoelements (5), welches einen Aktorbereich (6) und einen Sensorbereich (7) aufweist;
- Anlegen einer elektrischen Spannung an den Aktorbereich (6) des Kompensationspiezoelements (5);
- Vorsehen einer elektrischen Verbindung zwischen dem Sensorbereich (7) des Kompensationspiezoelements (5) und dem Sensorabschnitt (4) des Piezoelements (2).

12. Verfahren nach Anspruch 11, **dadurch gekennzeichnet, dass** an den Aktorbereich (6) des Kompensationspiezoelements (5) eine elektrische Spannung angelegt wird, die gleich groß, jedoch invers zu der an den Aktorabschnitt (3) des Piezoelements (2) angelegten elektrischen Spannung ist.

13. Verfahren nach Anspruch 11, **dadurch gekennzeichnet, dass** an den Aktorbereich (6) des Kompensationspiezoelements (5) die gleiche elektrische Spannung wie an den Aktorabschnitt (3) des Piezoelements (2) angelegt wird, und dass der Sensorabschnitt (4) des Piezoelements (2) elektrisch invers mit dem Sensorbereich (7) des Kompensationspiezoelements (5) verbunden wird.

## Claims

1. Device (1) for setting the crosstalk between an actuator section (3) and a sensor section (4) of a piezo element (2), a force being applied to the piezo element (2), with the result that an externally acting force to be measured using the sensor section (4) acts on the piezo element (2), and an electrical voltage being applied to the actuator section (3), **characterized in that**
the device (1) also comprises a force-free compensation piezo element (5) which has an actuator region (6) and a sensor region (7), an electrical voltage likewise being applied to the actuator region (6), and the sensor section (4) of the piezo element (2) and the sensor region (7) of the compensation piezo element (5) being electrically connected to one another.

2. Device according to Claim 1,
**characterized in that**
an electrical voltage which is the same as but inverse to that applied to the actuator section (3) of the piezo element (2) is applied to the actuator region (6) of the compensation piezo element (5).

3. Device according to Claim 1,
**characterized in that**
the same electrical voltage as that applied to the actuator section (3) of the piezo element (2) is applied to the actuator region (6) of the compensation piezo element (5), and **in that** the sensor section (4) of the piezo element (2) is electrically inversely connected to the sensor region (7) of the compensation piezo element (5).

4. Device according to Claim 1,
**characterized in that**
the same electrical voltage as that applied to the actuator section (3) of the piezo element (2) is applied to the actuator region (6) of the compensation piezo element (5), and **in that** the sensor section (4) of the piezo element (2) has a polarity which is inverse to that of the sensor region (7) of the compensation piezo element (5).

5. Device according to at least one of the preceding claims,
**characterized in that**
the piezo element (2) and/or the compensation piezo element (5) has/have a multilayer structure at least in sections.

6. Device according to at least one of the preceding claims,
**characterized in that**
the structure of the piezo element (2) differs from the structure of the compensation piezo element (5) at least in sections.

7. Device according to at least one of the preceding claims,
**characterized in that**
the piezo element (2) has a different piezoelectric ceramic from the compensation piezo element (5) at least in sections.

8. Device according to at least one of the preceding claims,
**characterized in that**
the piezo element (2) has a different geometry from the compensation piezo element (5) at least in sections.

9. Component having a device according to at least one of the preceding claims.

10. Component according to Claim 9,
**characterized in that**
the piezo element (2) is mechanically integrated in the component.

11. Method for setting the crosstalk between an actuator section (3) and a sensor section (4) of a piezo element (2), comprising the following steps of:
- applying an electrical voltage to the actuator section (3) of the piezo element (2), thus resulting in deformation of the piezo element (2);
- applying a force which externally acts on the piezo element (2);
- providing a force-free compensation piezo element (5) which has an actuator region (6) and a sensor region (7);
- applying an electrical voltage to the actuator region (6) of the compensation piezo element (5);
- providing an electrical connection between the sensor region (7) of the compensation piezo element (5) and the sensor section (4) of the piezo element (2).

12. Method according to Claim 11,
**characterized in that**
an electrical voltage which is of the same magnitude as but inverse to the electrical voltage applied to the actuator section (3) of the piezo element (2) is applied to the actuator region (6) of the compensation piezo element (5).

13. Method according to Claim 11,
**characterized in that**
the same electrical voltage as that applied to the actuator section (3) of the piezo element (2) is applied to the actuator region (6) of the compensation piezo element (5), and **in that** the sensor section (4) of the piezo element (2) is electrically inversely connected to the sensor region (7) of the compensation piezo element (5).

## Revendications

1. Dispositif (1) de réglage de la diaphonie entre une section d'actionneur (3) et une section de capteur (4) d'un élément piézoélectrique (2), l'élément piézoélectrique (2) étant soumis à une force, de sorte qu'une force agissant depuis l'extérieur, à mesurer au moyen de la section de capteur (4), agit sur l'élément piézoélectrique (2) et une tension électrique étant appliquée à la section d'actionneur (3),
**caractérisé en ce que**
le dispositif (1) comprend en plus un élément piézoélectrique de compensation (5) sans force, lequel présente une zone d'actionneur (6) et une zone de capteur (7), une tension électrique étant également appliquée à la zone d'actionneur (6) et la section de capteur (4) de l'élément piézoélectrique (2) et la zone de capteur (7) de l'élément piézoélectrique de compensation (5) étant reliées électriquement entre elles.

2. Dispositif selon la revendication 1,
**caractérisé en ce que**
la tension électrique appliquée à la zone d'actionneur (6) de l'élément piézoélectrique de compensation (5) est la même que celle appliquée à la section d'actionneur (3) de l'élément piézoélectrique (2), mais inverse.

3. Dispositif selon la revendication 1,
**caractérisé en ce que**
la tension électrique appliquée à la zone d'actionneur (6) de l'élément piézoélectrique de compensation (5) est la même que celle appliquée à la section d'actionneur (3) de l'élément piézoélectrique (2) et que la section de capteur (4) de l'élément piézoélectrique (2) est reliée de manière électriquement inversée avec la zone de capteur (7) de l'élément piézoélectrique de compensation (5).

4. Dispositif selon la revendication 1,
**caractérisé en ce que**
la tension électrique appliquée à la zone d'actionneur (6) de l'élément piézoélectrique de compensation (5) est la même que celle appliquée à la section d'actionneur (3) de l'élément piézoélectrique (2) et que la section de capteur (4) de l'élément piézoélectrique (2) présente une polarité inverse par rapport à la zone de capteur (7) de l'élément piézoélectrique de compensation (5).

5. Dispositif selon au moins l'une des revendications précédentes,
**caractérisé en ce que**
l'élément piézoélectrique (2) et/ou l'élément piézoélectrique de compensation (5) présente/présentent au moins dans certaines sections une structure multicouche.

6. Dispositif selon au moins l'une des revendications précédentes,
**caractérisé en ce que**
la structure de l'élément piézoélectrique (2) se différentie au moins dans certaines sections de la structure de l'élément piézoélectrique de compensation (5) .

7. Dispositif selon au moins l'une des revendications précédentes,
**caractérisé en ce que**
l'élément piézoélectrique (2) présente au moins dans certaines sections une céramique piézoélectrique différente de celle de l'élément piézoélectrique de compensation (5).

8. Dispositif selon au moins l'une des revendications précédentes,
**caractérisé en ce que**
l'élément piézoélectrique (2) présente au moins dans certaines sections une géométrie différente de celle de l'élément piézoélectrique de compensation (5).

9. Composant muni d'un dispositif selon au moins l'une des revendications précédentes.

10. Composant selon la revendication 9,
**caractérisé en ce que**
l'élément piézoélectrique (2) est intégré mécaniquement dans le composant.

11. Procédé de réglage de la diaphonie entre une section d'actionneur (3) et une section de capteur (4) d'un élément piézoélectrique (2), comprenant les étapes suivantes:
- Application d'une tension électrique à la section d'actionneur (3) de l'élément piézoélectrique (2), ce qui provoque une déformation de l'élément piézoélectrique (2);
- Exercice d'une force agissant depuis l'extérieur sur l'élément piézoélectrique (2);
- Réalisation d'un élément piézoélectrique de compensation (5) sans force, lequel présente une zone d'actionneur (6) et une zone de capteur (7);
- Application d'une tension électrique à la zone d'actionneur (6) de l'élément piézoélectrique de compensation (5);
- Réalisation d'une liaison électrique entre la zone de capteur (7) de l'élément piézoélectrique de compensation (5) et la section de capteur (4) de l'élément piézoélectrique (2).

12. Procédé selon la revendication 11,
**caractérisé en ce que**
une tension électrique est appliquée à la zone d'actionneur (6) de l'élément piézoélectrique de compensation (5) laquelle a la même valeur, mais l'inverse de la tension électrique appliquée à la section d'actionneur (3) de l'élément piézoélectrique (2).

13. Procédé selon la revendication 11,
**caractérisé en ce que**
la tension électrique appliquée à la zone d'actionneur (6) de l'élément piézoélectrique de compensation (5) est la même que celle appliquée à la section d'actionneur (3) de l'élément piézoélectrique (2) et que la section de capteur (4) de l'élément piézoélectrique (2) est reliée de manière électriquement inversée avec la zone de capteur (7) de l'élément piézoélectrique de compensation (5).
